# EUROPEAN PATENT APPLICATION

(11) **EP 4 783 802 A1**
(43) Date of publication of application: **29.07.2026**
(21) Application number: 23956184.8
(22) Date of filing: 19.10.2023
(51) Int. Cl.: H10K 59/80, H10K 59/121

(54) **DISPLAY DEVICE**

(71) Applicant: LG Electronics Inc., Yeongdeungpo-gu Seoul 07336 (KR)
(72) Inventor: LEE, Baekki, Seoul 06772 (KR); IM, Sungmo, Seoul 06772 (KR); CHO, Hyuncheol, Seoul 06772 (KR); KEE, Wondo, Seoul 06772 (KR)
(74) Representative: Vossius & Partner Patentanwälte Rechtsanwälte mbB
(86) International application number: PCT/KR2023/016248
(87) International publication number: WO 2025/084462

(57) **Abstract**

This display device comprises: a display panel comprising an optical substrate having a TFT array layer mounted thereon; a cover panel covering the periphery of the rear surface of the optical substrate; a support panel located below the rear surface of the optical substrate and having mounted thereon a printed circuit board for providing driving signals to the display panel; and a back cover covering the support panel and located below the rear surface of the optical substrate, wherein the cover panel comprises, at one end of the front surface thereof, a step formed to protrude toward the rear surface of the optical substrate. In the display device, the optical substrate having mounted thereon the TFT array layer constituting the rear surface of the display panel is exposed to thereby achieve heat dissipation and diversification of the exterior design.

## Description

### TECHNICAL FIELD

The present disclosure relates to a display device capable of dissipating heat and allowing various exterior designs by exposing an optical substrate forming the rear surface of a display panel and having a TFT array seated thereon.

### BACKGROUND

With growth of information society, demand for various display devices has increased. In order to satisfy such demand, in recent years, a liquid crystal display (LCD), a field emission display (FED), a plasma display panel (PDP), and an electroluminescent device have been developed as display devices.

Currently, the most prominent commercially available display devices are represented by LCDs and organic light emitting diodes (OLEDs). However, the LCDs are not able to emit light on their own and thus require a backlight unit to irradiate light, which presents a problem in that it is difficult to implement a flexible form factor.

Unlike the LCDs, the OLEDs emit light autonomously without a backlight unit structure, making it easier to implement flexibility and thus enabling realization of various types of display devices. Further, the OLEDs provide advantages in response speed and viewing angles due to the absence of a backlight unit, thereby drawing attention as next-generation displays.

Additionally, as displays have recently become larger, a method for reducing the weight and thickness of a display device while simultaneously lowering manufacturing costs is required. The importance of the exterior design of the display device is also emphasized to meet the needs of consumers.

### DISCLOSURE

### TECHNICAL PROBLEM

The present disclosure relates to a display device. More particularly, an object of the present disclosure is to provide a display device capable of dissipating heat and enabling various exterior designs by exposing an optical substrate forming the rear surface of a display panel and having a TFT array seated thereon.

Further, an object of the present disclosure is to provide a display device capable of reducing a weight and a thickness while lowering manufacturing costs through modification of the structure and shape of a cover positioned on the rear surface of a display panel.

Further, an object of the present disclosure is to provide a display device capable of meeting consumer needs regarding exterior design by printing and exposing various patterns on the rear surface of an optical substrate.

The object of the present disclosure are not limited to the above-mentioned effects, and other objects not mentioned will be clearly understood by those skilled in the art to which the present disclosure pertains from the following description.

### TECHNICAL SOLUTION

A display device is provided, including: a display panel including an optical substrate on which a TFT array layer is seated; a cover panel covering a periphery of a rear surface of the optical substrate; a support panel positioned on a lower part of the rear surface of the optical substrate and having mounted thereon a printed circuit board providing a driving signal to the display panel; and a back cover covering the support panel and positioned on the lower part of the rear surface of the optical substrate. The cover panel includes a stepped portion formed at one end of a front surface thereof to protrude toward the rear surface of the optical substrate.

The display device may further include an adhesive member applied between the front surface of the cover panel and the rear surface of the optical substrate, and the adhesive member may be hidden by the stepped portion of the cover panel.

The stepped portion of the cover panel may be spaced apart from the rear surface of the optical substrate to form a gap.

The optical substrate may include a pattern printed on a rear surface thereof, and the pattern may be exposed to an outside between the cover panel and the back cover.

The display device may further include reinforcing members attached to both corners of an upper part of a rear surface of the cover panel.

The cover panel may include a side portion formed to surround a side periphery of the display panel.

The cover panel may include an inclined surface formed to be inclined toward one side of a rear surface thereof.

The display device may further include a support bar coupled to the cover panel and fixing the support panel.

The display device may further include a heat sink positioned between the rear surface of the optical substrate and the printed circuit board mounted on the support panel.

The display panel may include an OLED formed on the TFT array layer.

### ADVANTAGEOUS EFFECTS

A display device according to the present disclosure may dissipate heat and enable various exterior designs by exposing an optical substrate forming the rear surface of a display panel and having a TFT array seated thereon.

Further, the weight and thickness of the display device may be reduced while lowering manufacturing costs through modification of the structure and shape of a cover positioned on the rear surface of the display panel.

Further, consumer needs regarding exterior design may be met by printing and exposing various patterns on the rear surface of the optical substrate.

The effects obtained by the present disclosure are not limited to the above-mentioned effects, and other effects not mentioned will be clearly understood by those skilled in the art to which the present disclosure pertains from the following description.

### BRIEF DESCRIPTION OF THE DRAWINGS

FIG. 1 is a block diagram illustrating components of a display device according to the present disclosure.
FIG. 2 is an exploded view illustrating a display device according to an embodiment of the present disclosure.
FIG. 3 is a rear view illustrating a display device according to an embodiment of the present disclosure.
FIG. 4 is a cross-sectional view comparatively illustrating a conventional display device and a display device according to an embodiment of the present disclosure.
FIG. 5 is a diagram illustrating a pattern printed on the rear surface of an optical substrate in a display device according to an embodiment of the present disclosure.
FIG. 6 is a cross-sectional view illustrating another embodiment of a display device according to the present disclosure.
FIG. 7 is a diagram illustrating a reinforcing member attached to the rear surface of a cover panel in a display device according to an embodiment of the present disclosure.
FIG. 8 is a diagram illustrating a support bar for fixing a support panel in a display device according to an embodiment of the present disclosure.

### DETAILED DESCRIPTION

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

Meanwhile, an image display device described in this specification is, for example, an intelligent image display device having a computer supporting function in addition to a broadcast reception function, wherein an Internet function may be added while the broadcast reception function is devotedly performed, whereby an interface that is more conveniently used, such as a handwriting type input device, a touchscreen, or a space remote control, may be provided. In addition, the image display device may be connected to the Internet or a computer through support of a wired or wireless Internet function, whereby various functions, such as e-mail, web browsing, banking, or gaming, may be executed. For such various functions, a standardized general-purpose OS may be used.

In the image display device described in the present disclosure, therefore, various applications may be freely added or deleted, for example, on a general-purpose OS kernel, whereby various user friendly functions may be executed. More specifically, the image display device may be a network TV, an Hbb TV, or a smart TV, and is applicable to a smartphone depending on circumstances.

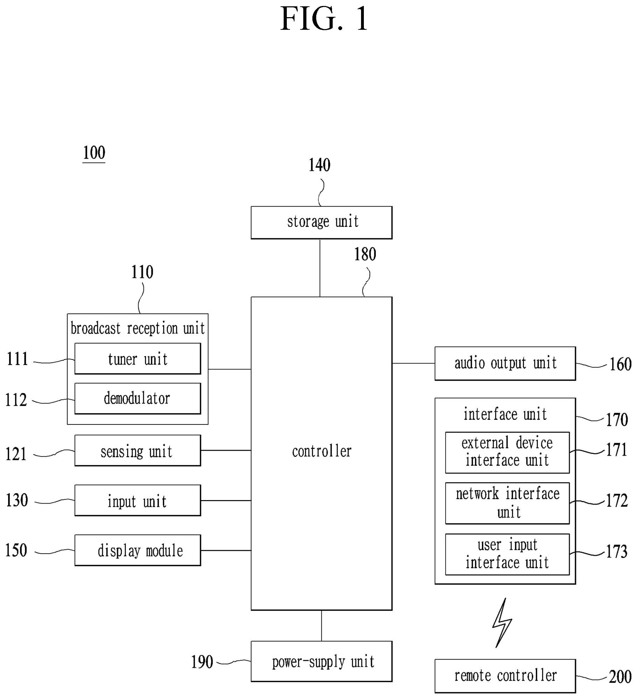

FIG. 1 is a block diagram illustrating components of a display device 100. The display device 100 may include a broadcast reception unit 110, an external device interface unit 171, a network interface unit 172, a storage unit 140, a user input interface unit 173, an input unit 130, a controller 180, a display module 150, an audio output unit 160, and/or a power supply unit 190.

The broadcast reception unit 110 may include a tuner unit 111 and a demodulation unit 112.

Unlike the figure, on the other hand, the display device 100 may include only the external device interface unit 171 and the network interface unit 172, among the broadcast reception unit 110, the external device interface unit 171, and the network interface unit 172. That is, the display device 100 may not include the broadcast reception unit 110.

The tuner unit 111 may select a broadcast signal corresponding to a channel selected by a user or any one of all pre-stored channels, among broadcast signals received through an antenna (not shown) or a cable (not shown). The tuner unit 111 may convert the selected broadcast signal into an intermediate frequency signal or a baseband video or audio signal.

For example, when the selected broadcast signal is a digital broadcast signal, the tuner unit 111 may convert the broadcast signal into a digital IF (DIF) signal, and when the selected broadcast signal is an analog broadcast signal, the tuner unit 111 may convert the broadcast signal into an analog baseband video or audio (CVBS/SIF) signal. That is, the tuner unit 111 may process the digital broadcast signal or the analog broadcast signal. The analog baseband video or audio (CVBS/SIF) signal output from the tuner unit 111 may be directly input to the controller 180.

Meanwhile, the tuner unit 111 may sequentially select broadcast signals of all broadcast channels stored through a channel memory function, among received broadcast signals, and may convert each of the selected broadcast signals into an intermediate frequency signal or a baseband video or audio signal.

Meanwhile, the tuner unit 111 may include a plurality of tuners in order to receive broadcast signals of a plurality of channels. Alternatively, a single tuner may simultaneously receive broadcast signals of a plurality of channels.

The demodulation unit 112 may receive the digital IF (DIF) signal converted by the tuner unit 111, and may perform demodulation. After performing demodulation and channel decryption, the demodulation unit 112 may output a stream signal (TS). At this time, the stream signal may be a multiplexed image, audio, or data signal.

The stream signal output from the demodulation unit 112 may be input to the controller 180. After performing demultiplexing and image/audio signal processing, the controller 180 may output an image through the display module 150, and may output audio through the audio output unit 160.

The sensing unit 120 is a device configured to sense change inside or outside the display device 100. For example, the sensing unit 120 may include at least one of a proximity sensor, an illumination sensor, a touch sensor, an infrared (IR) sensor, an ultrasonic sensor, an optical sensor (e.g. a camera), an audio sensor (e.g. a microphone), a battery gauge, and an environmental sensor (e.g. a hygrometer or a thermometer).

The controller 180 may check the state of the display device 100 based on information collected by the sensing unit, and when a problem occurs, may inform a user of the same or may solve the problem, whereby the controller may perform control such that the display device is maintained in the best state.

In addition, the controller may differently control the content, quality, and size of an image provided to the display module 150 based on a viewer or ambient light sensed by the sensing unit in order to provide the optimum viewing environment. With progress of a smart TV, a large number of functions have been loaded in the display device, and the sensing unit 20 has also been increased in number.

The input unit 130 may be provided at one side of a main body of the display device 100. For example, the input unit 130 may include a touchpad or a physical button. The input unit 130 may receive various user commands related to the operation of the display device 100, and may transmit control signals corresponding to the received commands to the controller 180.

With a decrease in size of a bezel of the display device 100, many display devices 100 have been configured such that the number of physical button type input units 130 exposed to the outside is minimized in recent years. Instead, a minimum number of physical buttons is located at the rear surface or the side surface of the display device, and the display device may receive user input through the touchpad or the user input interface unit 173, a description of which will follow, using a remote controller 200.

The storage unit 140 may store programs for signal processing and control in the controller 180, and may store a processed image, audio, or data signal. For example, the storage unit 140 may store application programs designed to execute various tasks that can be processed by the controller 180, and may selectively provide some of the stored application programs in response to request of the controller 180.

Programs stored in the storage unit 140 are not particularly restricted as long as the programs can be executed by the controller 180. The storage unit 140 may temporarily store an image, audio, or data signal received from an external device through the external device interface unit 171. The storage unit 140 may store information about a predetermined broadcast channel through a channel memory function, such as a channel map.

FIG. 1 shows an embodiment in which the storage unit 140 and the controller 180 are separately provided; however, the present disclosure is not limited thereto. The storage unit 140 may be included in the controller 180.

The storage unit 140 may include at least one of a volatile memory (e.g. DRAM, SRAM, or SDRAM), a nonvolatile memory (e.g. flash memory), a hard disk drive (HDD), and a solid-state drive (SSD).

The display module 150 may convert an image signal, a data signal, an OSD signal, and a control signal processed by the controller 180 or an image signal, a data signal, and a control signal received from the interface unit 171 to generate a driving signal. The display module 150 may include a display panel 181 having a plurality of pixels.

The display module 150 may include a micro LED module according to an embodiment of the present disclosure, which will be described below.

The display module 150 may be implemented as a flexible display, and also as a 3D display. The 3D display module 150 may be classified as a glasses-free autostereoscopic type or a glasses-wearing type.

The display device 100 may include the display module 150 occupying most area of a front surface thereof, and a case that covers rear and side surfaces of the display module 150 to package the display module 150.

LCDs, which have been primarily used in the past, receive light through a backlight unit because the LCDs have difficulty in autonomously emitting light. A backlight unit is a device that supplies light from a light source uniformly to a liquid crystal layer positioned at the front. Although thinner LCDs may be realized as backlight units became slimmer, it is difficult to implement a backlight unit using a flexible material. Moreover, when the backlight unit is bent, it becomes difficult to supply uniform light to the liquid crystal, resulting in fluctuation of screen brightness.

In contrast, in the case of light emitting diodes (LEDs) or organic light emitting diodes (OLEDs), the elements forming each pixel emit light autonomously, allowing for flexible implementation without the use of a backlight unit. Additionally, since each element is self-emissive, its own brightness is not affected even if the positional relationship with neighboring elements changes, and thus, a flexible display module 150 may be realized.

OLEDs emerged in earnest in the mid-2010s and are rapidly replacing LCDs in the small-to-medium-sized display market. An OLED is a display made using a self-emissive phenomenon where light is emitted when current flows through fluorescent organic compounds. Since its image response speed is faster than that of an LCD, almost no afterimages appear when displaying a video.

OLEDs use three types of fluorescent organic compounds, Red, Green, and Blue, which have self-emissive functions. Because OLEDs are a light-emitting display product utilizing the phenomenon where electrons and positively charged particles injected from a cathode and an anode are combined within an organic material to emit light on their own, there is no need for backlights which degrade color expression.

The display module 150 may include a coupling magnet, a first power supply unit, and a first signal module.

In the display module 150, a side displaying an image may be referred to as a front or front surface. When the display module 150 displays an image, a side from which an image is not observable may be referred to as a rear or rear surface. Meanwhile, the display module 150 may be constituted by a touchscreen, whereby an input device may also be used in addition to an output device.

The audio output unit 160 receives an audio signal processed by the controller 180 and outputs the same as audio.

The interface unit 170 serves as a path to various kinds of external devices connected to the display device 100. The interface unit may include a wireless system using an antenna as well as a wired system configured to transmit and receive data through a cable.

The interface unit 170 may include at least one of a wired/wireless headset port, an external charger port, a wired/wireless data port, a memory card port, a port for connection with a device having an identification module, an audio input/output (I/O) port, a video input/output (I/O) port, and an earphone port.

The broadcast reception unit 110 may be included as an example of the wireless system, and a mobile communication signal, a short-range communication signal, and a wireless Internet signal as well as a broadcast signal may be included.

The external device interface unit 171 may transmit or receive data to or from a connected external device. To this end, the external device interface unit 171 may include an A/V input and output unit (not shown).

The external device interface unit 171 may be connected to an external device, such as a digital versatile disc (DVD) player, a Blu-ray player, a game console, a camera, a camcorder, a computer (laptop computer), or a set-top box, in wired/wireless manner, and may perform input/output operation for the external device.

In addition, the external device interface unit 171 may establish a communication network with various remote controllers 200 in order to receive a control signal related to the operation of the display device 100 from each remote controller 200 or to transmit data related to the operation of the display device 100 to each remote controller 200.

The external device interface unit 171 may include a wireless communication unit (not shown) for short-range wireless communication with another electronic device. The external device interface unit 171 may exchange data with a mobile terminal adjacent thereto through the wireless communication unit (not shown). Particularly, in a mirroring mode, the external device interface unit 171 may receive device information, information of an application that is executed, and an image of the application from the mobile terminal.

The network interface unit 172 may provide an interface for connection of the display device 100 with a wired/wireless network including the Internet. For example, the network interface unit 172 may receive content or data provided by an Internet or content provider or a network operator through the network. Meanwhile, the network interface unit 172 may include a communication module (not shown) for connection with the wired/wireless network.

The external device interface unit 171 and/or the network interface unit 172 may include a communication module for short-range communication, such as Wi-Fi, Bluetooth, Bluetooth Low Energy (BLE), ZigBee, or Near Field Communication (NFC), or a communication module for cellular communication, such as Long-Term Evolution (LTE), LTE Advance (LTE-A), Code Division Multiple Access (CDMA), Wideband CDMA (WCDMA), Universal Mobile Telecommunications System (UMTS), or Wireless Broadband (WiBro).

The user input interface unit 173 may transmit a user input signal to the controller 180, or may transmit a signal from the controller 180 to a user. For example, the user input interface unit may transmit/receive a user input signal, such as power on/off, channel selection, or screen setting, to/from the remote controller 200, may transmit a user input signal, such as a power key, a channel key, a volume key, or a setting value, input from a local key (not shown) to the controller 180, may transmit a user input signal input from a sensor unit (not shown) configured to sense user gesture to the controller 180, or may transmit a signal from the controller 180 to the sensor unit.

The controller 180 may include at least one processor, and may control the overall operation of the display device 100 using the processor included therein. Here, the processor may be a general processor, such as a central processing unit (CPU). Of course, the processor may be a dedicated device, such as an ASIC, or another hardware-based processor.

The controller 180 may demultiplex a stream input through the tuner unit 111, the demodulation unit 112, the external device interface unit 171, or the network interface unit 172, or may process demultiplexed signals to generate and output a signal for image or audio output.

An image signal processed by the controller 180 may be input to the display module 150, which may display an image corresponding to the image signal. In addition, the image signal processed by the controller 180 may be input to an external output device through the external device interface unit 171.

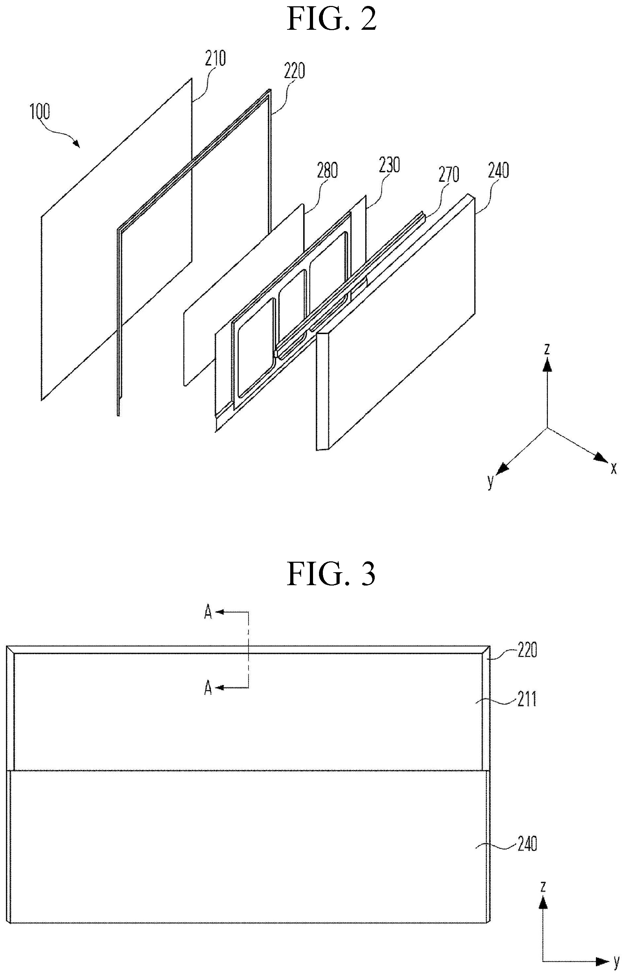

An audio signal processed by the controller 180 may be output through the audio output unit 160. In addition, the audio signal processed by the controller 180 may be input to an external output device through the external device interface unit 171. Although not shown in FIG. 2, the controller 180 may include a demultiplexing unit and an image processing unit, which will be described below with reference to FIG. 3.

Further, the controller 180 may control the overall operation of the display device 100. For example, the controller 180 may control the tuner unit 111 such that a broadcast corresponding to a channel selected by a user or a pre-stored channel is tuned.

In addition, the controller 180 may control the display device 100 according to a user command input through the user input interface unit 173 or an internal program. Meanwhile, the controller 180 may control the display module 150 to display an image. At this time, the image displayed on the display module 150 may be a still image or video, or may be a 2D image or a 3D image.

Meanwhile, the controller 180 may perform control such that a predetermined 2D object is displayed in an image displayed on the display module 150. For example, the object may be at least one of a connected web screen (newspaper or magazine), an electronic program guide (EPG), various menus, a widget, an icon, a still image, video, and text.

Meanwhile, the controller 180 may modulate and/or demodulate a signal using an amplitude shift keying (ASK) method. Here, the amplitude shift keying (ASK) method may be a method of changing the amplitude of a carrier depending on a data value to modulate a signal or restoring an analog signal to a digital data value depending on the amplitude of a carrier.

For example, the controller 180 may modulate an image signal using the amplitude shift keying (ASK) method, and may transmit the modulated image signal through a wireless communication module.

For example, the controller 180 may demodulate and process an image signal received through the wireless communication module using the amplitude shift keying (ASK) method.

As a result, the display device 100 may easily transmit and receive a signal to and from another image display device disposed adjacent thereto without using a unique identifier, such as a media access control (MAC) address, or a complicated communication protocol, such as TCP/IP.

Meanwhile, the display device 100 may further include a photographing unit (not shown). The photographing unit may photograph a user. The photographing unit may be implemented by one camera; however, the present disclosure is not limited thereto. The photographing unit may be implemented by a plurality of cameras. Meanwhile, the photographing unit may be embedded in the display device 100 above the display module 150, or may be separately disposed. Image information photographed by the photographing unit may be input to the controller 180.

The controller 180 may recognize the location of a user based on an image captured by the photographing unit. For example, the controller 180 may recognize the distance between the user and the display device 100 (z-axis coordinate). Further, the controller 180 may recognize an x-axis coordinate and a y-axis coordinate in the display module 150 corresponding to the location of the user.

The controller 180 may sense user gesture based on the image captured by the photographing unit, a signal sensed by the sensor unit, or a combination thereof.

The power supply unit 190 may supply power to the components of the display device 100. In particular, the power supply unit may supply power to the controller 180, which may be implemented in the form of a system on chip (SOC), the display module 150 for image display, and the audio output unit 160 for audio output.

Specifically, the power supply unit 190 may include an AC/DC converter (not shown) configured to convert AC power into DC power and a DC/DC converter (not shown) configured to convert the level of the DC power.

Meanwhile, the power supply unit 190 serves to distribute power supplied from the outside to the respective components of the display device. The power supply unit 190 may be directly connected to an external power supply in order to supply AC power, or may include a battery so as to be used by charging.

In the former case, a cable is used, and the power supply unit is difficult to move or the movement range of the power supply unit is limited. In the latter case, the power supply unit is free to move, but the weight of the power supply unit is increased in proportion to the weight of the battery, the volume of the power supply unit is increased, and, for charging, the power supply unit must be directly connected to a power cable or must be coupled to a charging holder (not shown) that supplies power for a predetermined time.

The charging holder may be connected to the display device through a terminal exposed to the outside, or the battery mounted in the power supply unit may be charged in a wireless manner when the power supply unit approaches the charging holder.

The remote controller 200 may transmit user input to the user input interface unit 173. To this end, the remote controller 200 may use Bluetooth communication, radio frequency (RF) communication, infrared radiation communication, ultra-wideband (UWB) communication, or ZigBee communication. In addition, the remote controller 200 may receive an image, audio, or data signal output from the user input interface unit 173 so as to be displayed thereon or audibly output therefrom.

Meanwhile, the display device 100 may be a stationary or movable digital broadcast receiver capable of receiving a digital broadcast.

Meanwhile, the block diagram of the display device 100 shown in FIG. 1 is for an embodiment of the present disclosure, and elements of the block diagram may be integrated, added, or omitted depending on specifications of an actually implemented display device 100.

That is, two or more elements may be integrated into one element, or one element may be divided into two or more elements, as needed. In addition, the function performed by each block is for describing the embodiment of the present disclosure, and the specific operations and components thereof do not limit the scope of rights of the present disclosure.

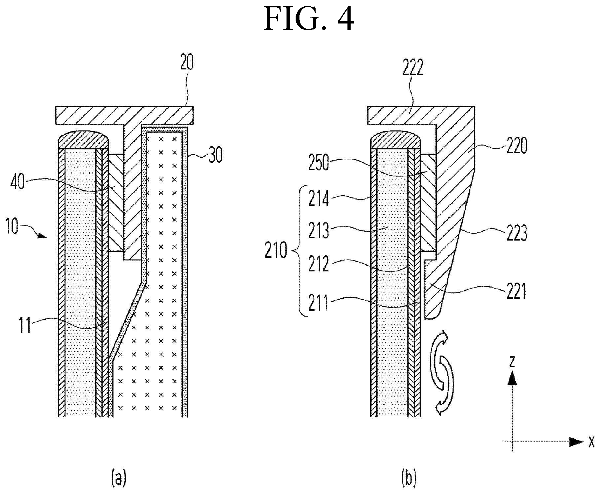

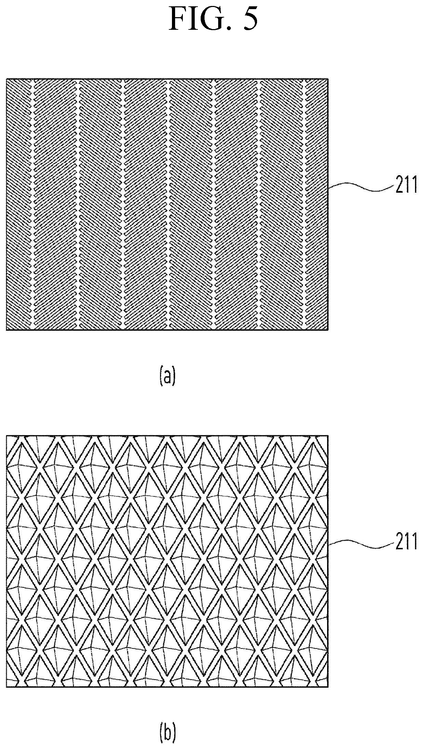

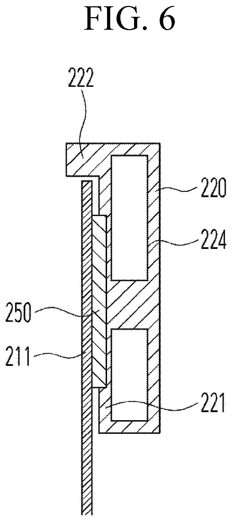

FIG. 2 is an exploded view illustrating the display device 100 according to an embodiment of the present disclosure. FIG. 3 is a rear view illustrating the display device 100 according to an embodiment of the present disclosure. FIG. 4 is a cross-sectional view comparatively illustrating a conventional display device 100 and the display device 100 according to an embodiment of the present disclosure. FIG. 5 is a diagram illustrating patterns printed on a rear surface of an optical substrate 211 in the display device 100 according to an embodiment of the present disclosure. FIG. 6 is a cross-sectional view illustrating another embodiment of the display device 100 of the present disclosure.

In describing the display device 100 according to an embodiment of the present disclosure, forward and rearward directions will be described based on an x-axis direction, a left-right direction on a y-axis direction, and an up-down direction on a z-axis direction.

The display device 100 according to an embodiment of the present disclosure may include a display panel 210, a cover panel 220, a support panel 230, and a back cover 240. As illustrated in FIG. 4, the display panel 210 from which an image is output may include the optical substrate 211 having a TFT array layer 212 seated thereon. That is, the optical substrate 211 may form a rear surface of the display panel 210. In this case, the optical substrate 211 may be formed of a metallic material. Further, OLEDs may be formed on the TFT array layer 212.

Further, in the display device 100 according to an embodiment of the present disclosure, the display panel 210 may include a glass 213 seated on the TFT array layer 212, and include a front cover 214 positioned on a front surface of the glass 213, as illustrated in FIG. 4.

The cover panel 220 may cover a periphery of the rear surface of the optical substrate 211. As illustrated in FIG. 2, the cover panel 220 may cover a portion of the periphery of the rear surface of the optical substrate 211, or it may be formed in a rim shape to cover the entire periphery of the rear surface.

The support panel 230 may be positioned on a lower part of the rear surface of the optical substrate 211. A printed circuit board that provides a driving signal to the display panel 210 may be mounted on the support panel 230. The back cover 240 may cover the support panel 230 and be positioned on the lower part of the rear surface of the optical substrate 211.

Through this configuration, in the display device 100 according to an embodiment of the present disclosure, an upper part of the optical substrate 211 forming the rear surface of the display panel 210 may be exposed, as illustrated in FIG. 3. More specific relevant details will be described below.

FIG. 4 is a cross-sectional view comparatively illustrating a conventional display device and the display device 100 according to an embodiment of the present disclosure. (a) of FIG. 4 is a cross-sectional view illustrating the conventional display device, taken along a line A-A of FIG. 3, and (b) of FIG. 4 is a cross-sectional view illustrating the display device 100 according to an embodiment of the present disclosure, taken along the line A-A of FIG. 3.

The conventional display device illustrated in (a) of FIG. 4 includes an optical substrate 11 forming a rear surface of a display panel 10, a cover panel 20 covering peripheries of side and rear surfaces of the display panel 10, and a back cover 30 coupled to the cover panel 20 and covering the entire rear surface of the display panel 10. The cover panel 20 is adhered to a rear surface of the optical substrate 11 by an adhesive member 40.

However, as described above, displays have recently become larger, and accordingly, there is a demand for a method for reducing the weight and thickness of the display device 100 while lowering manufacturing costs. In addition, the importance of the exterior design of the display device 100 is emphasized to meet consumer needs.

Therefore, as illustrated in FIG. 3 and (b) of FIG. 4, the display device 100 according to an embodiment of the present disclosure may have a reduced weight and thickness while lowering manufacturing costs through modification of the structures and shapes of the cover panel 220 and the back cover 240 positioned on the rear surface of the display panel 210. Further, the exterior design may be diversified by exposing the optical substrate 211 forming the rear surface of the display panel 210.

In the display device 100 according to an embodiment of the present disclosure, an adhesive member 250 such as OCA may be applied between a front surface of the cover panel 220 and the rear surface of the optical substrate 211 to bond and couple the two members.

In order to minimize the external exposure of the adhesive member 250 applied between the front surface of the cover panel 220 and the rear surface of the optical substrate 211, the cover panel 220 may include a stepped portion 221 formed at one end of the front surface thereof to protrude toward the rear surface of the optical substrate 211. The adhesive member 250 may then be hidden by the stepped portion 221 of the cover panel 220. Accordingly, even if the shape of the back cover 240 is modified, the external exposure of the adhesive member 250 may be minimized through the stepped portion 221 formed on the cover panel 220.

Further, in the display device 100 according to an embodiment of the present disclosure, the stepped portion 221 of the cover panel 220 may be spaced apart from the rear surface of the optical substrate 211 to form a gap. This is a means for preventing damage that may be applied to the periphery of the rear surface of the optical substrate 211 by the cover panel 220 exposed to the outside due to a change in the shape of the back cover 240.

In addition, as the stepped portion 221 of the cover panel 220 is spaced apart from the rear surface of the optical substrate 211 to form a gap, it is possible to minimize damage to the periphery of the rear surface of the optical substrate 211 that may occur when coupling the cover panel 220 to the rear surface of the optical substrate 211 through the adhesive member 250. Therefore, in an embodiment of the present disclosure, the gap between the stepped portion 221 of the cover panel 220 and the rear surface of the optical substrate 211 may be approximately 0.2mm.

Further, in the display device 100 according to an embodiment of the present disclosure, the cover panel 220 may include a side portion 222 formed to surround a side periphery of the display panel 210. Further, as described above, since the cover panel 220 is a member forming the exterior of the display device 100 of the present disclosure, it may include an inclined surface 223 formed to be inclined toward one side of a rear surface thereof as a design element.

In addition, the display device 100 according to an embodiment of the present disclosure may be more advantageous for the heat dissipation structure of the display panel 210 by exposing the optical substrate 211 through modification of the structures and shapes of the cover panel 220 and the back cover 240 positioned on the rear surface of the display panel 210.

In this regard, the conventional display device illustrated in (a) of FIG. 4, the back cover 30 directly contacts the rear surface of the metallic optical substrate 11 to discharge heat to the outside through thermal conduction. On the contrary, the display device 100 according to an embodiment of the present disclosure may discharge heat in a convective manner through the optical substrate 211 exposed to the outside, as illustrated in (b) of FIG. 4.

Referring also to FIG. 2, the display device 100 according to an embodiment of the present disclosure may further include a heat sink 280 positioned between the rear surface of the optical substrate 211 and the printed circuit board mounted on the support panel 230. That is, the display device 100 of the present disclosure may be advantageous in terms of the aforementioned heat dissipation structure of the display panel 210 by additionally positioning the heat sink 280 on the lower part of the optical substrate 211 that is not exposed to the outside.

FIG. 5 is a diagram illustrating a pattern printed on the rear surface of the optical substrate 211 in the display device 100 according to an embodiment of the present disclosure. (a) and (b) of FIG. 5 illustrate various embodiments of the pattern.

In the display device 100 according to an embodiment of the present disclosure, the optical substrate 211 may include a pattern printed on the rear surface thereof. Referring also to FIG. 3, the pattern printed on the rear surface of the optical substrate 211 may be exposed to the outside between the cover panel 220 and the back cover 240.

Accordingly, the display device 100 of the present disclosure may meet consumer needs regarding exterior design by exposing various patterns printed on the rear surface of the optical substrate 211 that is exposed to the outside.

FIG. 6 is a cross-sectional view illustrating another embodiment of the display device 100 of the present disclosure. Referring also to (b) of FIG. 4, the shape of the cover panel 220 covering the periphery of the rear surface of the optical substrate 211 may vary. That is, the weight of the cover panel 220 may be reduced by further forming at least one hole 224 in the cover panel 220. Through this, the weight of the display device 100 may be reduced, and manufacturing costs may be lowered while reducing the thickness compared to the conventional device.

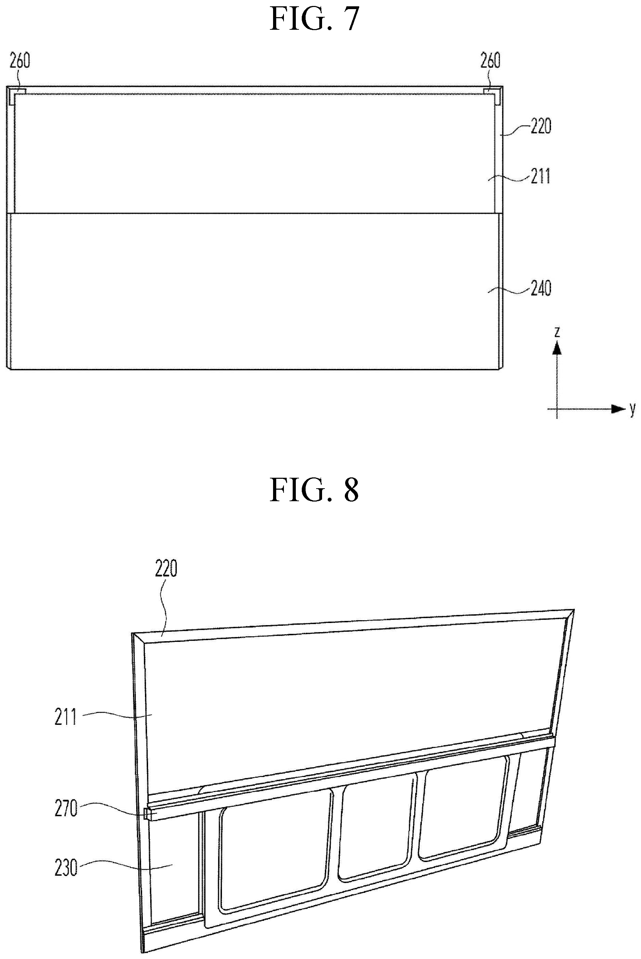

FIG. 7 is a diagram illustrating a reinforcing member 260 attached to the rear surface of the cover panel 220 in the display device 100 according to an embodiment of the present disclosure. FIG. 8 is a diagram illustrating a support bar 270 for fixing the support panel 230 in the display device 100 according to an embodiment of the present disclosure.

As described above, since the cover panel 220 covering the periphery of the rear surface of the optical substrate 211 forms the exterior of the display device 100 of the present disclosure, the display device 100 according to an embodiment of the present disclosure may further include reinforcing members 260 attached to both corners of an upper part of the rear surface of the cover panel 220 to ensure rigidity. Through the reinforcing members 260, it is possible to prevent damage to the optical substrate 211 forming the rear surface of the display panel 210 and the cover panel 220 covering the periphery of the rear surface of the optical substrate 211 caused by external impacts or the like.

Further, referring to FIGS. 2 and 8 together, the display device 100 according to an embodiment of the present disclosure may further include the support bar 270 coupled to the cover panel 220 to fix the support panel 230. The support panel 230 may be coupled to the cover panel 220 through a coupling surface formed to extend in the left-right direction on a lower part thereof. Then, the support bar 270 may be coupled to the rear surface of the support panel 230, and both ends of the support bar 270 may be coupled to the cover panel 220 to stably fix the cover panel 220 and the support panel 230.

In summary of the above description, the display device according to the present disclosure allows for heat dissipation and the diversification of exterior design by exposing the optical substrate forming the rear surface of the display panel and having the TFT array layer seated thereon. In addition, manufacturing costs may be lowered while reducing the weight and thickness of the display device by modifying the structure and shape of the cover positioned on the rear surface of the display panel. Further, consumer needs regarding exterior design may be met by printing and exposing various patterns on the rear surface of the optical substrate.

The above detailed description should not be construed as being limitative in all terms, but should be considered as being illustrative. The scope of the present disclosure should be determined by reasonable analysis of the accompanying claims, and all changes in the equivalent range of the present disclosure are included in the scope of the present disclosure.

## Claims

1. A display device comprising:
a display panel including an optical substrate on which a TFT array layer is seated;
a cover panel covering a periphery of a rear surface of the optical substrate;
a support panel positioned on a lower part of the rear surface of the optical substrate and having mounted thereon a printed circuit board providing a driving signal to the display panel; and
a back cover covering the support panel and positioned on the lower part of the rear surface of the optical substrate,
wherein the cover panel includes a stepped portion formed at one end of a front surface thereof to protrude toward the rear surface of the optical substrate.

2. The display device of claim 1, further comprising an adhesive member applied between the front surface of the cover panel and the rear surface of the optical substrate,
wherein the adhesive member is hidden by the stepped portion of the cover panel.

3. The display device of claim 2, wherein the stepped portion of the cover panel is spaced apart from the rear surface of the optical substrate to form a gap.

4. The display device of claim 1, wherein the optical substrate includes a pattern printed on a rear surface thereof, and
wherein the pattern is exposed to an outside between the cover panel and the back cover.

5. The display device of claim 1, further comprising reinforcing members attached to both corners of an upper part of a rear surface of the cover panel.

6. The display device of claim 1, wherein the cover panel includes a side portion formed to surround a side periphery of the display panel.

7. The display device of claim 6, wherein the cover panel includes an inclined surface formed to be inclined toward one side of a rear surface thereof.

8. The display device of claim 1, further comprising a support bar coupled to the cover panel and fixing the support panel.

9. The display device of claim 1, further comprising a heat sink positioned between the rear surface of the optical substrate and the printed circuit board mounted on the support panel.

10. The display device of claim 1, wherein the display panel includes an OLED formed on the TFT array layer.
